Europäisches Patentamt

European Patent Office

Office européen des brevets

(19)

(11) **EP 0 549 412 B1**

(12) **FASCICULE DE BREVET EUROPEEN**

(45) Date de publication et mention
de la délivrance du brevet:
**22.10.1997 Bulletin 1997/43**

(51) Int Cl.⁶: **G11B 20/14**, H03L 7/06

(21) Numéro de dépôt: **92403413.5**

(22) Date de dépôt: **15.12.1992**

(54) **Circuit d'horloge pour système de lecture d'informations séquentielles**

**Zeittaktschaltung für Lesegerät für sequentielle Daten**

Clock circuit for serial data reading system

(84) Etats contractants désignés:
**DE GB NL**

(30) Priorité: **23.12.1991 FR 9116046**

(43) Date de publication de la demande:
**30.06.1993 Bulletin 1993/26**

(73) Titulaire: **THOMSON-CSF**
**75008 Paris (FR)**

(72) Inventeurs:
• **Colineau, Joseph c/o Thomson-CSF, SCPI**
**F-92403 Courbevoie Cedex (FR)**
• **Audoin, Michel c/o Thomson-CSF, SCPI**
**F-92403 Courbevoie Cedex (FR)**

(74) Mandataire: **Guérin, Michel et al**
**THOMSON-CSF-S.C.P.I.,**
**13, Avenue du Président**
**Salvador Allende**
**94117 Arcueil Cédex (FR)**

(56) Documents cités:
EP-A- 0 239 413          EP-A- 0 274 704
WO-A-84/00435          US-A- 4 731 676

• **IBM TECHNICAL DISCLOSURE BULLETIN. vol.
21, no. 6, Novembre 1978, NEW YORK US page
2246 D.L. AHONEN 'Bit synchroniser using
matched delays'**
• **PATENT ABSTRACTS OF JAPAN vol. 9, no. 195
(P-379)(1918) 13 Août 1985 & JP-A-60 061 959**

**Description**

L'invention concerne un circuit d'horloge pour système de lecture d'informations séquentielles. Elle est applicable par exemple à la lecture d'informations enregistrées sur bande magnétique, sur disques magnétiques ou sur disques optiques, notamment dans les périphériques informatiques.

Dans un enregistreur numérique, le décodage des informations binaires passe par la régénération du signal de référence temporelle (horloge) qui a servi à l'enregistrement des informations. Cette horloge est le plus souvent réalisée par un oscillateur (VCO : voltage controlled oscillator) inséré dans une boucle à verrouillage de phase (PLL : phase locked loop) qui se synchronise sur les transitions du signal de lecture.

Dans un enregistreur multipiste, il est possible d'utiliser une seule horloge reconstruite pour l'ensemble des pistes, à condition que la synchronisation entre toutes les pistes inscrites sur la bande soit conservée. Ceci suppose que les têtes d'enregistrement et les têtes de lecture soient alignées, et que la bande ne se déforme pas. Si ces conditions ne sont pas strictement respectées, les références temporelles des diverses pistes se décalent les unes par rapport aux autres (phénomènes de glissement ou "skew"). Il est possible de compenser les défauts de skew s'ils ne sont pas trop importants.

Dans les autres cas, et en particulier dans les enregistreurs réalisant une haute densité d'informations selon le sens longitudinal de lecture du média d'enregistrement, et comportant un grand nombre de pistes parallèles, il est impossible de maintenir le skew suffisamment faible pour pouvoir le compenser sur l'ensemble des pistes. Il est alors nécessaire de réaliser un circuit de régénération d'horloge indépendant pour chaque piste, ce qui conduit à avoir un grand nombre de circuits.

L'invention a pour but de diminuer ce nombre de circuits d'horloge. Selon l'invention la réalisation numérique du régénérateur d'horloge permet, avec un seul ensemble d'opérateurs, de réaliser les opérations nécessaires séquentiellement sur un grand nombre de pistes, conduisant à une simplification importante de l'électronique. L'invention tire profit des corrélations qui existent entre les horloges de chacune des pistes.

Ce circuit séquentiel selon l'invention permet d'améliorer sensiblement les performances de l'ensemble du système.

L'invention a pour objet un circuit d'horloge pour système de lecture d'informations séquentielles pour la lecture de plusieurs séries d'informations enregistrées tel que décrit dans la revendication 1.

Les différents caractéristiques de l'invention apparaîtront plus clairement dans la description qui va suivre faite à titre d'exemple et dans les figures annexées qui représentent :

- la figure 1a, un schéma de principe d'une bande à verrouillage réalisée sous forme analogique ;
- la figure 1b, un schéma de principe d'une boucle à verrouillage de phase numérique ;
- la figure 2, un exemple de réalisation détaillé d'un circuit de poursuite de phase tel qu'utilisé dans l'invention ;
- les figures 3, 4 et 6, des exemples de réalisation du circuit de l'invention ;
- la figure 5, une organisation de tête de lecture et d'inscription sur bande d'enregistrement.

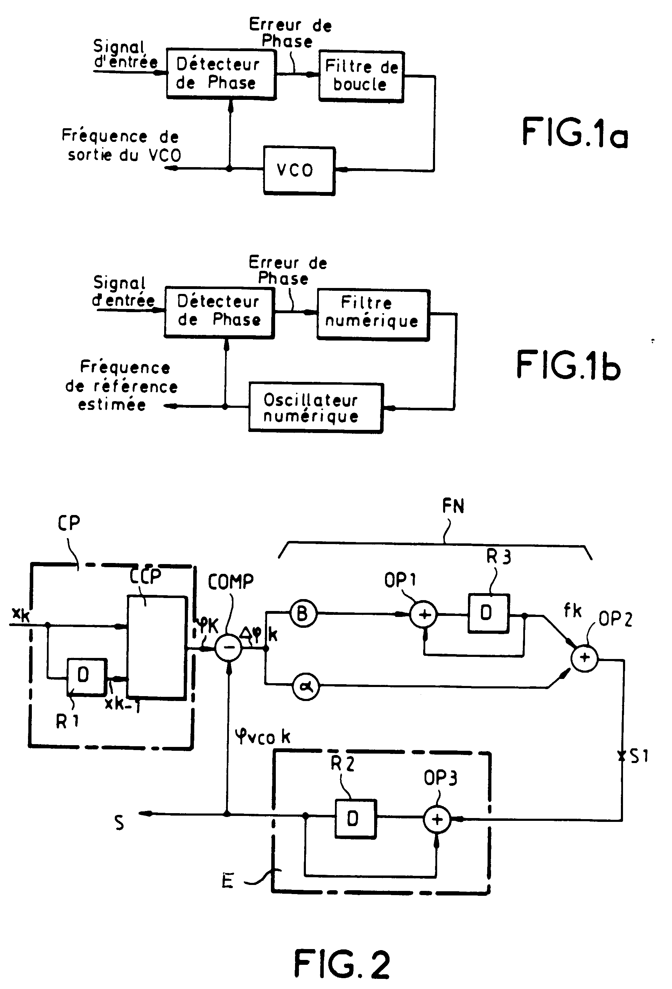

Le circuit de la figure 2 comporte une entrée de lecture $x_k$ sur laquelle arrivent de façon séquentielle les informations d'une piste enregistrée. Par exemple, cette piste enregistrée peut être une piste d'une bande d'enregistrement.

Un circuit de calcul CP de la phase du signal reçoit les informations lues et calcule la phase du signal à partir des valeurs de deux échantillons successifs lorsqu'ils sont de signes opposés. Pour cela un circuit R1 mémorise une information lue et un circuit de calcul CCP calcule la différence de phase entre l'instant de détection d'un signal et l'instant de détection d'un signal suivant.

Une boucle à verrouillage de phase comportant un circuit de comparaison de phase COMP compare la phase entre la phase calculée du signal et celle fournie par un circuit E.

Un filtre numérique FN filtre le signal d'erreur de phase et élabore un signal de contrôle de l'oscillateur.

Le circuit E délivre sur la sortie S un signal dont la fréquence et la phase sont contrôlées par le signal filtré du filtre numérique FN. Les circuits OP1, OP2, OP3 sont des opérateurs additionneurs. Le rôle du circuit de la figure 2 est d'élaborer, pour chaque nouvel échantillon de signal $x_k$, une estimation de la phase de cet échantillon, la référence de phase étant l'horloge bit (oscillateur VCO), c'est-à-dire les instants théoriques de transition. Lorsqu'il y a une transition du signal, le circuit de calcul de phase peut délivrer une valeur mesurée de la phase du signal, et après filtrage, cette nouvelle valeur sert à actualiser l'estimation de phase.

L'algorithme proposé pour ajuster l'instant de décision optimal ou pour suivre la phase du signal à démoduler (dans le récepteur) est connu. Il est basé sur les équations suivantes :

$$\begin{cases} \phi_{vco}(k+1) = (\phi_{vco}(k) + \alpha\Delta\phi(k) + 2\pi Tef(k))_{2\pi} \\ F(k+1) = f(k) + \dfrac{\beta\Delta\phi(k)}{2\pi Te} \\ \Delta\phi(k) = (\phi_{signal}(k) - \phi_{vco}(k))_{2\pi} \end{cases}$$

avec Te : période d'échantillonnage fixe du système.

Si l'on normalise la fréquence et la phase, ce système d'équations peut être écrit plus simplement :

$$\begin{cases} \phi_{vco}(k+1) = (\phi_{vco}(k) + \alpha\Delta\phi(k) + f(k))_1 \\ F(k+1) = f(k) + \beta\Delta\phi(k) \\ \Delta\phi(k) = (\phi_{signal}(k) - \phi_{vco}(k))_1 \end{cases}$$

La phase future du signal est prédite en fonction de la phase actuelle du circuit, de sa période d'horloge, et d'une erreur de phase pondérée entre le signal d'entrée et le circuit E. La correction de l'écart de phase n'est appliquée que lorsqu'une mesure de la phase du signal est disponible ; sinon la phase de l'oscillateur est maintenue à une période prés.

Ces équations décrivent le fonctionnement d'une boucle à verrouillage de phase numérique du second ordre constituée par un circuit VCO fournissant un signal de fréquence f(k) et de phase $\Phi_{VCO}(k)$ entre le signal du VCO et un signal de référence (noté $F_{signal}$ OU $F_{S}$).

$\alpha$ et b sont des coefficients de pondération ajustant le poids de la dernière mesure effectuée et sont appelés paramètres de boucle. Les schémas blocs de boucles à verrouillage de phase analogique et numérique sont présentés en figures 1a et 1b.

Sur la figure 2, les différents circuits comportent des circuits à retard R1, R2, R3 qui ont pour temps de retard la période d'échantillonnage D du signal à lire. Selon cet exemple de réalisation, le support d'enregistrement étant une bande magnétique, on a un circuit tel que celui de la figure 2 par piste d'enregistrement.

La phase du signal est calculée à partir de la valeur de deux échantillons successifs lorsqu'il y a changement de signe entre ces deux échantillons. Le calcul est fait à partir d'une ROM selon la technique "look-up table".

Dans un système multipiste, n pistes sont lues simultanément. Selon le mode de réalisation et de mise en oeuvre du système de lecture, n échantillons correspondant aux n pistes lues sont disponibles simultanément à chaque instant d'échantillonnage, ou délivrés successivement pendant la durée de la période d'échantillonnage.

Le circuit de la figure 2 est applicable à un système multipistes ou plus généralement à un système à n pistes indépendantes. Pour cela, on le fera travailler successivement sur les échantillons de données correspondant à chacune des n pistes, dans leur ordre d'arrivée. Afin d'effectuer aux instants i+kn l'ensemble des opérations décrites par l'algorithme pour la piste i, on doit présenter à l'entrée des opérateurs, à ces instants, les grandeurs qu'il est nécessaire de conserver en mémoire, soit $(x_k, \Phi_k, f_k)$.

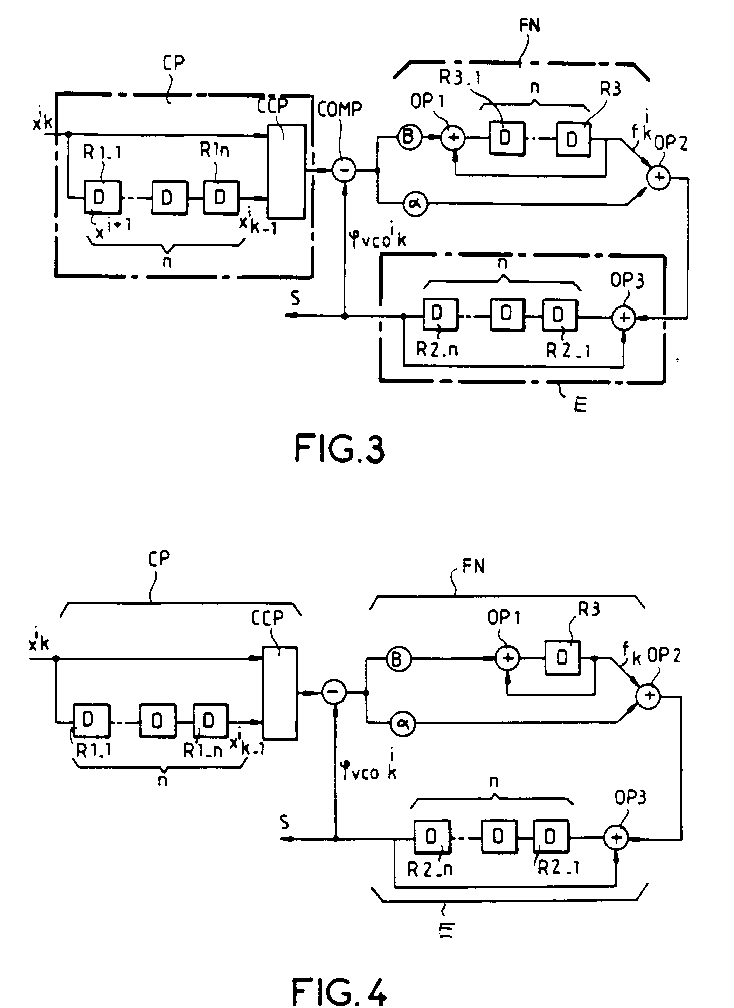

La figure 3 représente un exemple de réalisation dans lequel le support d'enregistrement comporte plusieurs pistes d'informations en parallèle.

Au lieu de prévoir un circuit d'horloge par piste, on prévoit un circuit d'horloge pour un nombre n de pistes.

Dans ce cas, chaque circuit à retard R1, R2, R3 est en fait un ensemble de n circuit à retard (correspondant au nombre n de pistes). En effet, les n pistes sont lues quasi simultanément et il s'agit d'affecter un signal d'horloge à chaque piste. Plus précisément, le circuit de calcul de phase CP est connecté sélectivement et successivement par des moyens de commutation non représentés au circuit d'entrée $x_k$.

Les circuits à retard constituent des registres à décalage de longueur n, ou des buffers circulaires réalisés à partir de RAM, permettant de conserver les résultats intermédiaires de chacune des n pistes à traiter. A l'instant i+kn, les grandeurs $\phi_k^i, f_k^i, x_k^i, x_{k-1}^i$ correspondant à la piste i sont présentes aux entrées des opérateurs, et permettent l'estimation de $\phi_{k+1}^i$ et $f_{k+1}^i$. Un instant plus tard, la piste i+1 est traitée. Après n coups d'horloge, on traite à nouveau la piste i.

La boucle de phase précédemment décrite est du second ordre puisqu'elle estime deux paramètres du signal (fréquence et phase). L'estimation de la fréquence est rendue délicate par la grande précision requise. Compte tenu du rapport signal à bruit faible que l'on trouve typiquement dans un enregistreur à haute densité, le coefficient $\beta$ est petit (typiquement $5 \cdot 10^{-3}$), ce qui conduit à des calculs sur 16 ou 24 bits. Ceci entraîne également une phase d'accrochage (période transitoire au démarrage du processus) longue et délicate. Pour ces raisons, beaucoup de circuits d'horloge utilisés en enregistrement sont simplement des filtres du premier ordre.

Si l'on considère que la fréquence du signal est proportionnelle à la vitesse de la bande, et si les têtes sont alignées, alors la fréquence instantanée est sensiblement la même sur chacune des pistes. On peut alors améliorer sensiblement l'estimation de la fréquence sur une piste en la remplaçant par la moyenne des estimations faites sur l'ensemble des pistes. Ainsi, si l'on moyenne les résultats de n pistes indépendantes, le rapport signal à bruit pourra être amélioré de $\sqrt{n}$.

Comme cela est représenté en figure 4, le circuit est modifié de façon qu'un même registre mémoire R3 est utilisé pour stocker la fréquence de chacune des n pistes, réalisant ainsi une moyenne des n estimations individuelles de la fréquence.

Cette solution présente les avantages suivants :

- la fréquence est estimée avec une plus grande précision, ce qui conduit à une augmentation du gain et/ou de la bande passante de la boucle ;
- la phase d'accrochage est plus rapide, et la tenue en l'absence momentanée de signal sur une piste est améliorée, puisque l'ensemble des pistes contribuent à l'estimation. La probabilité que la plupart des pistes soit en défaut est très faible ;
- il est possible de sécuriser le système multipiste en dédiant une piste au contrôle de la vitesse, par l'enregistrement sur cette piste d'un signal à fréquence fixe, ou d'un code à fort contenu d'horloge (par exemple FM ou biphase) qui servira par ailleurs de piste de contrôle (enregistrement de time-code ou d'autres signaux de service) ;
- il devient possible d'utiliser des codes sans contrainte de longueur maximale sans transition (maximum run-length codes) : par exemple NRZ scramblé, ou d'utiliser des codes à fenêtre temporelle étroite : par exemple les codes Run Limited Length (RLL) de type (d, k) (1, x).

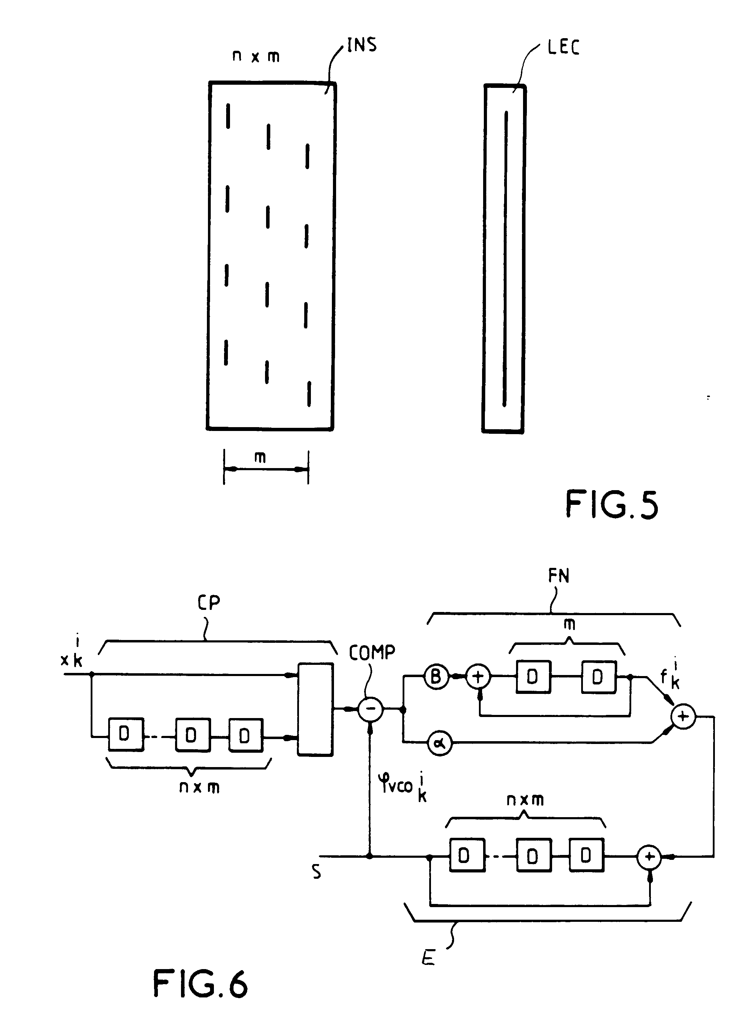

La figure 5 représente un exemple d'un enregistreur à têtes statiques, où les deux têtes n'ont pas la même géométrie : ici, la tête d'écriture INS a une géométrie "matricielle" c'est-à-dire que les entrefers sont disposés selon m lignes de n têtes, alors que la tête de lecture LEC a tous ses entrefers disposés en ligne. On ne peut alors considérer que la fréquence instantanée du signal n'est la même que pour les pistes dont les têtes d'écriture appartiennent à la même ligne verticale. On devra donc dans ce cas effectuer m estimations de la fréquence, pour les m groupes de n têtes. Ceci est obtenu grâce à un registre à décalage de m états. Bien entendu cette méthode est applicable au cas où la tête de lecture a aussi une structure matricielle.

La solution décrite ici, consistant à ne mettre en commun les estimations de fréquence des diverses pistes que lorsqu'elles sont proches s'étend aux cas où par suite du grand nombre de pistes et de la haute densité d'enregistrement, on ne peut plus considérer que la fréquence du signal est rigoureusement la même d'un bord à l'autre de la bande. Dans ce cas, on séparera les pistes par groupes présentant des caractéristiques voisines, et on utilisera autant de cases mémoires que de groupes à traiter distinctement.

Cette structure peut être utilisée dans bon nombre de circuits numériques multicanaux, lorsque des paramètres à estimer sont commun aux diverses voies.

La description qui précède n'a été faite qu'à titre d'exemple en application à la lecture d'informations sur bande. Cependant, le circuit de l'invention peut être utilisé dans tout autre type d'applications pour la lecture d'informations séquentielles (numériques notamment).

Dans ces types d'applications, il s'agira de préférence d'avoir à lire des informations dont certains paramètres à estimer sont communs aux différentes voies. Par ailleurs, les exemples de réalisation ne sont donnés que pour illustrer la description et d'autres variantes peuvent être envisagées sans sortir du cadre de l'invention, notamment dans les figures décrites, on a utilisé des circuits à retard mais on aurait pu utiliser des mémoires.

Egalement, pour l'entrée du circuit de calcul de phase CCP, il importe peu que les échantillons de signaux $x_k$ proviennent directement (et séquentiellement) du support d'enregistrement ou qu'ils proviennent de mémoires intermédiaires où elles ont été enregistrées simultanément.

**Revendications**

1. Circuit d'horloge pour système de lecture d'informations séquentielles pour la lecture de plusieurs séries d'informations enregistrées selon sensiblement une même période, sur plusieurs moyens d'enregistrement et nécessitant pour la lecture une période d'échantillonnage déterminée, caractérisé en ce qu'il comprend :

- un circuit de calcul de phase (CP) recevant les informations lues et calculant la phase de chaque signal à partir des valeurs de deux échantillons successifs de signes opposés d'une même série d'informations et fournissant un signal de phase calculé, ce circuit étant connectable sélectivement à différents moyens d'enregistrement et possédant un élément mémoire par série d'informations auquel est connectable le circuit de calcul de phase ;

- des moyens de commutation permettant de connecter sélectivement le circuit de calcul de phase sur les différents moyens d'enregistrement, la période de commutation de ces moyens de commutation étant telle que le temps séparant deux connexions successives du circuit de calcul de phase à un moyen d'enregistrement déterminé est sensiblement égal à un multiple de la période d'échantillonnage ;
- un circuit de comparaison de phase (COMP) recevant chaque signal de phase calculé ($\varphi_k$) et le comparant à un signal de phase d'oscillateur ($\varphi_{vcok}$) et fournissant un signal d'erreur de phase ($\Delta\varphi_k$) ;
- un filtre numérique (FN) recevant le signal d'erreur de phase ($\Delta\varphi_k$) le filtrant et fournissant un signal de contrôle d'oscillateur (S1) ;
- un circuit (E) recevant le signal de contrôle et fournissant un signal d'estimation de phase (S) pour chaque échantillon, ce circuit comportant un élément mémoire par série d'informations auquel est connectable le circuit de calcul de phase.

2. Circuit d'horloge selon la revendication 1, caractérisé en ce que le filtre numérique comporte un élément mémoire de signaux de phase calculé par série d'informations auxquelles est connectable le circuit de calcul de phase.

3. Circuit d'horloge selon la revendication 1, caractérisé en ce qu'il comporte un nombre m de groupes de n séries d'informations, le circuit de calcul de phase comporte m.n éléments mémoire, le circuit (E) comporte m.n éléments mémoire.

4. Circuit d'horloge selon la revendication 3, caractérisé en ce que le filtre numérique comporte m.n éléments mémoire.

5. Circuit d'horloge selon la revendication 3, caractérisé en ce que le filtre numérique comporte m éléments mémoire.

6. Circuit d'horloge selon l'une des revendications 1 ou 3, caractérisé en ce que le filtre numérique comporte un seul élément mémoire.

7. Circuit d'horloge selon l'une quelconque des revendications précédentes, caractérisé en ce que chaque élément mémoire comporte au moins un circuit à retard.

8. Circuit d'horloge selon la revendication 7, caractérisé en ce que dans le circuit de calcul de phase, dans le filtre numérique, et dans le circuit (E), la combinaison de plusieurs éléments mémoire est réalisée par la mise en série de plusieurs circuits à retard.

9. Circuit d'horloge selon la revendication 8, caractérisé en ce que chaque circuit à retard détermine un temps de retard correspondant à un temps de commutation séparant la connexion du circuit de calcul de phase à deux moyens d'enregistrement consécutifs.

10. Circuit selon la revendication 9, caractérisé en ce que le circuit (E) comporte une boucle à retard dont le temps de retard correspond à la période d'échantillonnage lecture des moyens d'enregistrement.

11. Circuit selon la revendication 9, caractérisé en ce que le circuit de calcul de phase comporte un circuit à retard dont le temps de retard correspond à la période d'échantillonnage des moyens d'enregistrement.

12. Circuit selon la revendication 9, caractérisé en ce que le filtre numérique comporte au moins un circuit à retard dont le temps de retard correspond à la période d'échantillonnage des moyens d'enregistrement.

13. Circuit selon l'une des revendications 10 à 12, caractérisé en ce que les moyens d'enregistrement comportent plusieurs séries d'un nombre déterminé n d'informations lues en parallèle, et chaque boucle à retard comporte un même nombre n de circuits à retard, la sommes des retards des circuits d'une boucle à retard étant égal à la période d'échantillonnage.

14. Circuit selon l'une des revendications 10 à 12, caractérisé en ce que les moyens d'enregistrement comportent une série d'un nombre déterminé n d'informations, le filtre numérique comporte un circuit à retard correspondant à la période d'échantillonnage du support d'enregistrement ; le circuit (E) et le circuit de calcul de phase comportent chacun ledit nombre déterminé n de circuit à retard dont la somme des retards correspond à la période d'échantillonnage du moyen d'enregistrement.

**15.** Circuit selon la revendication 13, caractérisé en ce qu'il comporte un seul circuit d'horloge commun aux différentes séries d'informations ; le circuit de calcul de phase et le circuit (E) comportent chacun un nombre de circuits à retards égal au nombre de séries d'informations n multiplié par le nombre d'informations contenues dans une série, la durée totale du retard de chacun de ces ensembles de circuits à retard étant égal à la période d'échantillonnage des informations à lire ; le filtre numérique comporte un nombre de circuits à retard égal au nombre d'informations contenues dans une série.

**16.** Circuit selon la revendication 1, caractérisé en ce que les différents moyens d'enregistrement sont réalisés sur un même support d'enregistrement.

**17.** Circuit selon la revendication 16, caractérisé en ce que le support d'enregistrement est une bande magnétique.

**Patentansprüche**

**1.** Taktgeberschaltung für System zum Lesen von sequentiellen Informationen, das mehrere Reihen von Informationen liest, die im wesentlichen mit derselben Periode in mehreren Aufzeichnungsmitteln aufgezeichnet sind und zum Lesen eine bestimmte Abtastperiode erfordern, dadurch gekennzeichnet, daß sie enthält:

- eine Phasenberechnungsschaltung (CP), die die gelesenen Informationen empfängt und die Phase jedes Signals anhand der Werte zweier aufeinanderfolgender Abtastwerte mit entgegengesetzten Vorzeichen derselben Reihe von Informationen berechnet und ein berechnetes Phasensignal liefert, wobei diese Schaltung wahlweise an verschiedene Aufzeichnungsmittel angeschlossen werden kann und ein Speicherelement für eine Reihe von Informationen besitzt, an das die Phasenberechnungsschaltung angeschlossen werden kann;
- Umschaltmittel, die ermöglichen, die Phasenberechnungsschaltung wahlweise an die verschiedenen Aufzeichnungsmittel anzuschließen, wobei die Umschaltperiode derart ist, daß die Zeit, um die zwei aufeinanderfolgende Vorgänge des Anschließens der Phasenberechnungsschaltung an ein bestimmtes Aufzeichnungsmittel getrennt sind, im wesentlichen gleich einem Vielfachen der Abtastperiode ist;
- eine Phasenvergleichsschaltung (COMP), die jedes berechnete Phasensignal ($\varphi_k$) empfängt, es mit einem Oszillator-Phasensignal ($\varphi_{vcok}$) vergleicht und ein Phasenfehlersignal ($\Delta\varphi_k$) liefert;
- ein digitales Filter (FN), das das Phasenfehlersignal ($\Delta\varphi_k$) empfängt, es filtert und ein Oszillator-Steuersignal (S1) liefert;
- eine Schaltung (E), die das Steuersignal empfängt und ein Phasenschätzsignal (S) für jeden Abtastwert liefert, wobei diese Schaltung ein Speicherelement für eine Reihe von Informationen enthält, an das die Phasenberechnungsschaltung angeschlossen werden kann.

**2.** Taktgeberschaltung nach Anspruch 1, dadurch gekennzeichnet, daß das digitale Filter ein Speicherelement für berechnete Phasensignale für eine Reihe von Informationen enthält, an das die Phasenberechnungsschaltung angeschlossen werden kann.

**3.** Taktgeberschaltung nach Anspruch 1, dadurch gekennzeichnet, daß sie eine Anzahl m von Gruppen von n Reihen von Informationen enthält, wobei die Phasenberechnungsschaltung m · n Speicherelemente enthält und die Schaltung (E) m · n Speicherelemente enthält.

**4.** Taktgeberschaltung nach Anspruch 3, dadurch gekennzeichnet, daß das digitale Filter m · n Speicherelemente enthält.

**5.** Taktgeberschaltung nach Anspruch 3, dadurch gekennzeichnet, daß das digitale Filter m Speicherelemente enthält.

**6.** Taktgeberschaltung nach einem der Ansprüche 1 oder 3, dadurch gekennzeichnet, daß das digitale Filter ein einziges Speicherelement enthält.

**7.** Taktgeberschaltung nach irgendeinem der vorangehenden Ansprüche, dadurch gekennzeichnet, daß jedes Speicherelement wenigstens eine Verzögerungsschaltung enthält.

**8.** Taktgeberschaltung nach Anspruch 7, dadurch gekennzeichnet, daß in der Phasenberechnungsschaltung, im digitalen Filter und in der Schaltung (E) die Kombination von mehreren Speicherelementen durch die Serienschaltung mehrerer Verzögerungsschaltungen verwirklicht ist.

9. Taktgeberschaltung nach Anspruch 8, dadurch gekennzeichnet, daß jede Verzögerungsschaltung eine Verzögerungszeit bestimmt, die einer Umschaltzeit entspricht, welche den Anschluß der Phasenberechnungsschaltung an zwei aufeinanderfolgende Aufzeichnungsmittel trennt.

10. Schaltung nach Anspruch 9, dadurch gekennzeichnet, daß die Schaltung (E) eine Verzögerungsschleife enthält, deren Verzögerungszeit der Lese-Abtastperiode der Aufzeichnungsmittel entspricht.

11. Schaltung nach Anspruch 9, dadurch gekennzeichnet, daß die Phasenberechnungsschaltung eine Verzögerungsschaltung enthält, deren Verzögerungszeit der Abtastperiode der Aufzeichnungsmittel entspricht.

12. Schaltung nach Anspruch 9, dadurch gekennzeichnet, daß das digitale Filter wenigstens eine Verzögerungsschaltung enthält, deren Verzögerungszeit der Abtastperiode der Aufzeichnungsmittel entspricht.

13. Schaltung nach einem der Ansprüche 10 bis 12, dadurch gekennzeichnet, daß die Aufzeichnungsmittel mehrere parallel gelesene Reihen mit einer bestimmten Anzahl n von Informationen enthalten und jede Verzögerungsschleife dieselbe Anzahl n von Verzögerungsschaltungen enthält, wobei die Summe der Verzögerungen der Schaltungen einer Verzögerungsschleife gleich der Abtastperiode ist.

14. Schaltung nach einem der Ansprüche 10 bis 12, dadurch gekennzeichnet, daß die Aufzeichnungsmittel eine Reihe mit einer bestimmten Anzahl n von Informationen enthalten, das digitale Filter eine Verzögerungsschaltung enthält, die der Abtastperiode des Aufzeichnungsträgers entspricht, und die Schaltung (E) und die Phasenberechnungsschaltung jeweils die bestimmte Anzahl n von Verzögerungsschaltungen enthalten, wobei die Summe von deren Verzögerungen der Abtastperiode des Aufzeichnungsmittels entspricht.

15. Schaltung nach Anspruch 13, dadurch gekennzeichnet, daß sie eine einzige Taktgeberschaltung enthält, die den verschiedenen Reihen von Informationen gemeinsam ist; die Phasenberechnungsschaltung und die Schaltung (E) jeweils eine Anzahl von Verzögerungsschaltungen enthalten, die gleich der Anzahl n der Reihen von Informationen, multipliziert mit der Anzahl n von in einer Reihe enthaltenen Informationen, ist, wobei die Gesamtdauer der Verzögerung jeder dieser Einheiten von Verzögerungsschaltungen gleich der Abtastperiode der zu lesenden Informationen ist; und das digitale Filter eine Anzahl von Verzögerungsschaltungen enthält, die gleich der Anzahl von in einer Reihe enthaltenen Informationen ist.

16. Schaltung nach Anspruch 1, dadurch gekennzeichnet, daß die verschiedenen Aufzeichnungsmittel auf demselben Aufzeichnungsträger verwirklicht sind.

17. Schaltung nach Anspruch 16, dadurch gekennzeichnet, daß der Aufzeichnungsträger ein Magnetband ist.

**Claims**

1. Clock circuit for a sequential-information reading system for the reading of several series of information items recorded substantially in a same period, on several recording means and necessitating, for the reading, a determined sampling period, characterized in that it comprises:

   - a phase computation circuit (CP) receiving the information items read and computing the phase of each signal from the values of two successive samples of opposite signs of a same series of information items and giving a computed phase signal, this circuit being capable of being connected selectively to different recording means, and having one memory element per series of information items, to which element the phase computation circuit can be connected;
   - switching means enabling the selective connection of the phase computation circuit to the different recording means, the period of switching of these switching means being such that the time separating two successive conections of the phase computation circuit to a determined recording means is substantially equal to a multiple of the sampling period;
   - a phase comparison circuit (comp) receiving each computed phase signal ($\phi_k$) and comparing it with an oscillator phase signal ($\phi_{vcok}$) and giving a phase error signal ($\Delta\phi_k$);
   - a digital filter (FN) receiving the phase error signal ($\Delta\phi_k$), filtering it and giving an oscillator control sigal (S1);

- a circuit (E) receiving the control signal and giving a phase estimation signal (S) for each sample, this circuit comprising one memory element per series of information items, to which element the phase computation circuit can be connected.

2. Clock circuit according to Claim 1, characterized in that the digital filter comprises one computed-phase signals memory element per series of information items to which the phase computation circuit can be connected.

3. Clock circuit according to Claim 1, characterized in that it comprises a number m of groups of n series of information items, the phase computation ciruit comprises m.n memory elements and the circuit (E) comprises m.n memory elementss.

4. Clock circuit according to Claim 3, characterized in that the digital filter comprises m.n memory elements.

5. Clock circuit according to Claim 3, characterized in that the digital filter comprises m memory elements.

6. Clock circuit according to either of Claims 1 and 3, characterized in that the digital filter comprises only one memory element.

7. Clock circuit according to any one of the preceding claims, characterized in that each memory element comprises at least one delay circuit.

8. Clock circuit according to Claim 7 characterized in that in the phase computation circuit, in the digital filter and in the circuit (E), the combination of several memory elements is achieved by the series connection of several delay circuits.

9. Clock circuit according to Claim 8, characterized in that each delay circuit determines a delay time corresponding to a switching time separating the connection of the phase computation circuit to two consecutive recording means.

10. Circuit according to Claim 9, characterized in that the circuit (E) comprises a delay loop, the delay time of which corresponds to the read period of sampling of the recording means.

11. Circuit according to Claim 9, characterized in that the phase computation circuit comprises a delay circuit, the delay time of which corresponds to the period of sampling of the recording means.

12. Circuit according to Claim 9, characterized in that the digital filter comprises at least one delay circuit, the delay time of which corresponds to the period of sampling of the recording means.

13. Circuit according to one of Claims 10 to 12, characterized in that the recording means comprise several series of a determined number n of information items read in parallel, and each delay loop comprises one and the same number n of delay circuits, the sums of the delays of the circuits of a delay loop being equal to the sampling period.

14. Circuit according to one of Claims 10 to 12, characterized in that the recording means comprise a series of a determined number n of information items, the digital filter comprises a delay circuit corresponding to the period of sampling of the recording medium; the circuit (E) and the phase computation circuit each comprise the said determined number n of delay circuits, the sum of the delays of which corresponds to the period of sampling of the recording means.

15. Circuit according to Claim 13, characterized in that it comprises a single clock circuit common to the different series of information items; the phase computation circuit and the circuit (E) each comprise a number of delay circuits equal to the number of series of information items n multiplied by the number of information items n contained in a series, the total duration of the delay of each of these sets of delay circuits being equal to the period of sampling of the information items to be read; the digital filter comprises a number of delay circuits equal to the number of information items contained in a series.

16. Circuit according to Claim 1, characterized in that the different recording means are made on a same recording medium.

17. Circuit according to Claim 16, characterized in that the recording medium is a magnetic tape.

FIG.1a

FIG.1b

FIG.2

FIG.3

FIG.4

FIG.5

FIG.6